Europäisches Patentamt

European Patent Office

Office européen des brevets

(11) Veröffentlichungsnummer : **0 075 220**
**B1**

(12) **EUROPÄISCHE PATENTSCHRIFT**

(45) Veröffentlichungstag der Patentschrift :
07.05.86

(51) Int. Cl.⁴ : **H 03 H  1/00, H 01 R  4/64**

(21) Anmeldenummer : **82108369.8**

(22) Anmeldetag : **10.09.82**

(54) **Entstörfilter.**

(30) Priorität : **18.09.81 DE 3137289**
**09.06.82 DE 3221809**

(43) Veröffentlichungstag der Anmeldung :
**30.03.83 Patentblatt 83/13**

(45) Bekanntmachung des Hinweises auf die Patenterteilung : **07.05.86 Patentblatt 86/19**

(84) Benannte Vertragsstaaten :
**AT BE CH DE FR GB IT LI LU NL SE**

(56) Entgegenhaltungen :
**DE-C-  909 356**
**FR-A- 2 164 654**
**GB-A- 1 007 385**
**US-A- 2 839 874**
**SIEMENS BAUTEILE REPORT, Band 15, Nr. 2, 1977, Seiten 81-84, Berlin-München, DE; B. STETTNER et al.: "Entstörfilter für elektronische Anlagen"**

(73) Patentinhaber : **Siemens Aktiengesellschaft Berlin und München Wittelsbacherplatz 2 D-8000 München 2 (DE)**

(72) Erfinder : **Kinzler, Hans, Dipl.-Ing. Roter Brach Weg 69 D-8400 Regensburg (DE)**

## Beschreibung

Die Erfindung betrifft ein Entstörfilter, insbesondere Netzleitungsfilter zur Funkentstörung von ein- und mehrphasigen angeschlossenen elektrischen Geräten und Maschinen, mit Entstördrosseln und Entstörkondensatoren, insbesondere HF-massekontaktierten Y-Kondensatoren, die in einen Metallbecher eingesetzt sind, der durch einen durch Ultraschall-Punktschweißen mit der Becherwandung verbundenen Metalldeckel verschlossen ist, und Durchführungen für elektrische Kabel bzw. Kabelstecker aufweist, von denen mindestens eines der Kabel mit einem Schutzleiter ausgerüstet ist, bzw. das Al-Gehäuse mit einem Schutzleiteranschluß, insbesondere mit einem Flachstecker z. B. gem. DIN 46244, ausgestattet ist, der über eine Masseleitung mit dem Metallbecher galvanisch kontaktiert ist.

In üblichen Entstörfiltern erfolgt die Masseverbindung zwischen dem Schutzleiter und Metallbecher durch Kupferdrähte von z. B. 1, 2 mm Durchmesser, wobei die Kontaktierung mit dem Metallbecher in Nähe der Kabeldurchführung durch den Metallbecher liegt. Angestrebt wird zusätzlich eine möglichst kurze Masseverbindung der Gehäuse der Entstörkondensatoren, insbesondere Y-Kondensatoren, mit dem Metallbecher. Zur Dämpfung hochfrequenter Störströme bzw. Störsignale ist die Masseleitung dabei durch zwei Ferrit-Rohrkerne geführt.

Die Metallbecher wurden bislang aus lötbaren Werkstoffen gefertigt und die Masseleitung durch Löten oder Schrauben mit dem Metallbecher verbunden. Mit zunehmender Verkleinerung der Entstörfilter und mit Steigerung ihrer Stückzahl wurde jedoch auf die kostengünstigeren, fließgepreßten Aluminiumbecher umgestellt und die Verbindung der Masseleitung mit dem Aluminiumbecher über ultraschallgeschweißte Kupferlötösen geschaffen. Die Verbindung des Metallbechers, der als Behälter für das fertig montierte und in Vergußmasse, z. B. Epoxidharz, eingebettete Entstörfilter dient, mit einem zwecks eines hochfrequenzdichten Abschlusses aus Aluminium bestehenden Deckels, erfolgt dabei gleichfalls durch Ultraschall-Punktschweißen. Nur durch Ultraschallschweißen läßt sich nämlich ein sicherer Schweißkontakt zwischen Aluminium und Kupfer und zwischen anderen lötbaren Werkstoffen erreichen. Diese Art der Montage der Masseleitung ist insbesondere auch für Entstörfilter mit sogenannter UL-Dimensionierung sehr aufwendig, da dort die Vorschrift besteht, daß Lötverbindungen der Masseleitung sich beim Erhitzen über den Erweichungspunkt des Lotes nicht lösen dürfen.

Die vorliegende Erfindung hat sich daher die Aufgabe gestellt, eine Lösung anzugeben, die eine einfachere Massekontaktierung der Schutzleiter und ggf. zusätzlich auch eine einfachere Massekontaktierung für die Entstör = insbesondere Y-Kondensatoren ermöglicht.

Die Erfindung sieht zur Schaffung einer einfacheren Massekontaktierung für die Schutzleiter vor, daß das mit dem Metallbecher galvanisch kontaktierte Ende der Masseleitung flach ausgebildet, zwischen Metallbecherinnenwand und Metalldeckel geklemmt und mittels Ultraschall-Punktschweißen mit dem Metallbecher und Metalldeckel verbunden ist.

Zweckmäßigerweise erfolgt die Ultraschall-Punktschweißung an einer bereits für die Verbindung des Metalldeckels mit dem Metallbecher bestimmten Schweißstelle, so daß beim Einschweißen des Metalldeckels das flache Ende der Masseleitung automatisch mit eingeschweißt wird. Durch die gewählte Art der Kontaktierung der Masseleitung entfällt die ansonsten erforderliche Masselötöse am Metallbecher und damit auch das Durchfädeln der Masseleitung durch die Lötöse, was insgesamt eine einfachere Montage des Entstörfilters ermöglicht. Der durch Ultraschall-Punktschweißen geschaffene Massekontakt ist i. ü. temperaturunabhängig.

In gleicher Weise wie die Masseleiter können bei freier Verdrahtung der Entstörfilter auch die Masseanschlußdrähte der Y-Kondensatoren an ihren mit dem Metallbecher galvanisch kontaktierten Enden flach ausgebildet, vorzugsweise flach geschlagen, zwischen Metallbecherwand und Metalldeckel geklemmt und mittels Ultraschall-Punktschweißen mit dem Metallbecher und Metalldeckel verbunden sein. Die erforderliche äußerst kurze Verbindung mit dem Metallbecher läßt sich so wenig aufwendig herstellen.

Setzt man die Bauelemente des Entstörfilters auf eine Leiterplatte, und schließt man die Anschlußenden der elektrischen Leiter der elektrischen Kabel, d. h. die Phasen-, Mittelpunkts- und Schutzleiter an diese Leiterplatte an, so läßt sich die Kontaktierung der einzelnen Elemente und Leiter durch Schwallöten und damit mit geringstmöglichen Aufwand durchführen.

Für diesen Fall können die üblicherweise auf der Leiterplatte befestigten Y-Kondensatoren über auf der Leiterplatte angeordnete Massepunkte und eine Kupferband mit der Metallbecherwand verbunden sein, wobei das Kupferband gleichfalls durch Schwallöten mit seinem einen Ende auf den Massepunkt aufgelötet wird und mit seinem anderen Ende zwischen Metallbecher und Metalldeckel eingeklemmt und durch Ultraschall-Punktschweißen mit diesem verbunden wird.

Die Erfindung wird nachstehend anhand von Ausführungsbeispielen näher erläutert. Es zeigt:

Figur 1 eine Draufsicht auf ein Entstörfilter nach der Erfindung in schematischer Darstellung, wobei der Metalldeckel abgenommen ist,

Figur 2 eine Draufsicht auf die Masseleitung nach Fig. 1,

Figur 3 einen Schnitt gemäß der Linie 3-3 in Fig. 1, wobei zur Veranschaulichung wesentliche Bauelemente des Entstörfilters nicht dargestellt sind,

Figur 4 die Masseleitung in der Ansicht nach Fig. 3,

Figur 5 in der Darstellung nach Fig. 3 einen Schnitt durch ein weiteres Ausführungsbeispiel für ein Entstörfilter nach der Erfindung, wobei zur Veranschaulichung die bereits in Figur 1, 2 dargestellten Elemente weggelassen wurden und lediglich die Massekontaktierung eines Y-Kondensators gezeigt ist,

Figur 6 eine Seitenansicht eines Entstörfilters nach der Erfindung, wobei das Al-Gehäuse mit einem getrennten Schutzleiteranschluß ausgerüstet ist.

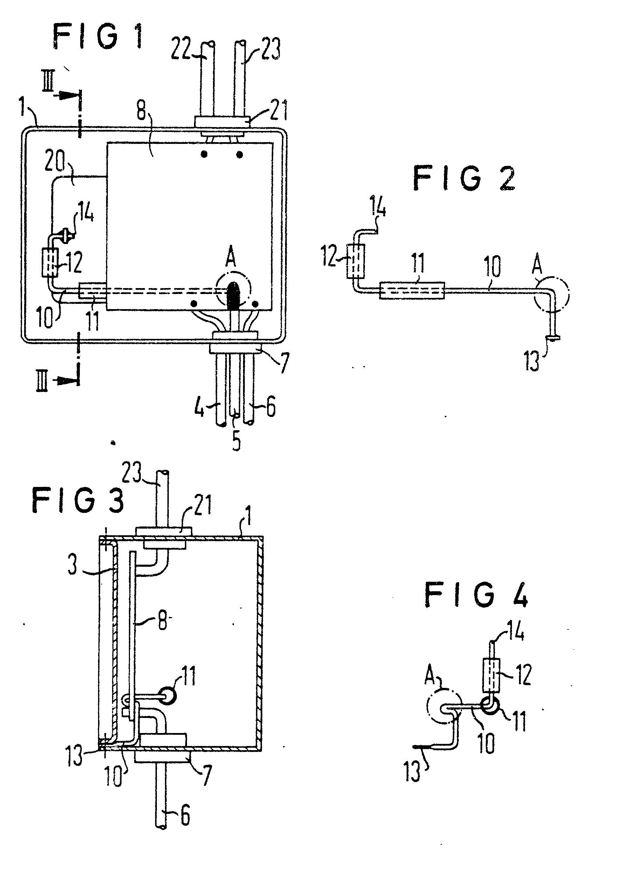

Das Entstörfilter nach Fig. 1 bis 4 besitzt einen Metallbecher 1 und Durchführungen 7 bzw. 21 für Kabel mit Leitern 4, 6 bzw. 22, 23, wobei ein Kabel zusätzlich mit einem Schutzleiter 5 ausgerüstet ist. Die elektrischen Bauelemente, nämlich Entstördrosseln und Entstörkondensatoren, insbesondere Y-Kondensatoren, die nicht dargestellt sind, sind auf eine Leiterplatte 8 aufgebracht. Die Anschlußenden der Leiter 4, 5, 6 bzw. 22, 23 sind, wie die Anschlußelemente der elektrischen Bauelemente, durch Schwallöten mit den entsprechenden Kontakten der Leiterbahn 8 kontaktiert. Eine Masseleitung 10 weist ein flach ausgebildetes, insbesondere flach geschlagenes oder flachgewalztes Drahtende 13 auf, das zwischen die Metallbecherinnenwand und einen Metalldeckel 3 geklemmt und mittels Ultraschall-Punktschweißen mit den Metallbecher 1 und Metalldeckel 3 verbunden ist.

Im gezeigten Ausführungsbeispiel ist die Masseleitung 10 im strichpunktiert angedeuteten Bereich A über die Leiterplatte 8 mit dem Schutzleiter 5 galvanisch kontaktiert. Zusätzlich ist die Masseleitung 10 mit ihrem Ende 14 mit dem Kaltgerätestecker 20 galvanisch verbunden. Zur Dämpfung hochfrequenter Störströme ist die Masseleitung 10 durch Ferrit-Rohrkerne 11, 12 geführt. Der Metalldeckel 3 ist durch Ultraschall-Punktschweißen mit dem Metallbecher 1 verbunden und gewährleistet so einen hochfrequenzdichten Verschluß des in eine Vergußmasse eingebetteten Entstörfilters.

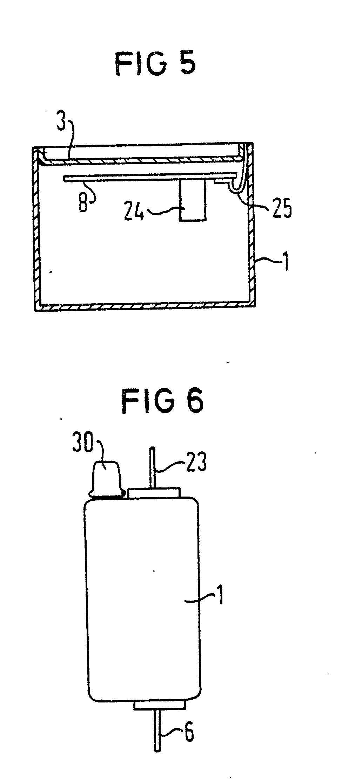

Die in Fig. 5 schematisch und vereinfacht dargestellte, weiterverbesserte Ausführung eines Entstörfilters, zeigt einen auf der Leiterplatte 8 befestigten Y-Kondensator 24, dessen Masseanschluß über ein Kupferband 25 erfolgt, das an seinem einen Ende durch Schwallöten auf den entsprechenden Massepunkt aufgelötet ist. Beim Einsatz des Entstörfilters in den Metallbecher wird das freie Ende des Kupferbandes 25 zunächst hochgebogen und schließlich nach dem Vergießen des Entstörfilters zwischen den Metallbecher 1 und den Metalldeckel 3 geklemmt und mit diesen durch Ultraschall-Punktschweißen kontaktiert. Das Kupferband 25 bietet erhebliche Vorteile. So greifen beim Schwallöten keine Verbindungsdrähte durch die Leiterplatte 8. Zusätzlich ist das Kupferband 25 induktivitätsärmer, wodurch insbesondere bei etwas größerer Bandlänge die Entstörwirkung des Entstörfilters nicht verschlechtert wird und schließlich kann die Kupferbandbreite so groß gewählt werden, daß beim Ultraschall-Schweißen das Kupferband 25 in jedem Fall, d. h. auch ohne aufwendige Einrichtungen « getroffen » wird.

Beim Entstörfilter nach Fig. 6 ist im Unterschied zu den vorhergehenden Anwendungsbeispielen der Schutzleiter über einen Flachstecker 30, z. B. nach DIN 46244, getrennt aus dem Gehäuseinneren herausgeführt.

**Patentansprüche**

1. Entstörfilter, insbesondere Netzleitungsfilter zur Funkentstörung von ein- und mehrphasig angeschlossenen elektrischen Geräten und Maschinen, mit Entstördrosseln und Entstörkondensatoren, insbesondere HF-massekontaktierten Y-Kondensatoren, die in einen Metallbecher (1) eingesetzt sind, der durch einen durch Ultraschall-Punktschweißen mit der Becherwandung verbundenen Metalldeckel (3) geschlossen ist und Durchführungen (7, 21) für elektrische Kabel bzw. Kabelstecker aufweist, von denen mindestens eines der Kabel mit einem Schutzleiter (5) ausgerüstet ist, der über eine Masseleitung (10) mit dem Metallbecher (1) galvanisch kontaktiert ist, oder das Steckergehäuse einen Schutzleiteranschluß hat, dadurch gekennzeichnet, daß das mit dem Metallbecher (1) galvanisch kontaktierte Ende (13) der Masseleitung (10) flach ausgebildet, zwischen Metallbecherinnenwand und Metalldeckel (3) geklemmt und mittels Ultraschall-Punktschweißen mit dem Metallbecher und Metalldeckel verbunden ist.

2. Entstörfilter nach Anspruch 1, dadurch gekennzeichnet, daß die Masseleitung (10) zusätzlich vom Schutzleiter (5) zum Kaltgerätestecker (20) geführt und mit dessen Gehäuse galvanisch kontaktiert ist.

3. Entstörfilter nach Anspruch 1 oder 2, dadurch gekennzeichnet, daß die Masseleitung (10) durch zwei Ferrit-Rohrkerne (11, 12) geführt ist.

4. Entstörfilter nach Anspruch 1, dadurch gekennzeichnet, daß zusätzlich die Masseanschlußdrähte der Y-Kondensatoren an ihren mit dem Metallbecher (1) galvanisch kontaktierten Enden flach ausgebildet, zwischen Metallbecherinnenwand und Metalldeckel (3) geklemmt und mittels Ultraschall-Punktschweißen mit dem Metallbecher und Metalldeckel verbunden sind.

5. Entstörfilter nach Anspruch 1 oder einem der vorhergehenden Ansprüche, dadurch gekennzeichnet, daß eine elektrische Leiterplatte (8) als Träger und/oder Kontaktplatte für die Bauelemente des Entstörfilters und für die Anschlußenden der elektrischen Leiter (4, 5, 6 bzw. 22, 23) vorgesehen ist, daß die vom Schutzleiter (5) zum Metallbecher (1) und ggf. zum Kaltgerätestecker (20) geführte Masseleitung (10) über die Leiterplatte (8) mit dem Schutzleiter kontaktiert ist, und daß sämtliche Leiterplattenkontakte schwallgelötet sind.

6. Entstörfilter nach Anspruch 1 oder 5, dadurch gekennzeichnet, daß mindestens ein Y-Kondensator (24) auf der Leiterplatte (8) angeordnet ist und daß der mit dem Masseanschluß des Y-Kondensators (24) kontaktierte Massepunkt der Leiterplatte mit einem Kupferband (25) galvanisch verbunden ist, das mit seinem freien Ende zwischen Metallbecherinnenwand und Metalldeckel (3) geklemmt und mittels Ultraschall-Punktschweißen mit dem Metallbecher (1) und Metalldeckel verbunden ist.

7. Entstörfilter nach Anspruch 6, dadurch gekennzeichnet, daß das eine Ende des Kupferbandes (25) mittels Schwallöten auf den Massepunkt der Leiterplatte (8) aufgelötet ist.

## Claims .

1. An interference suppression filter, in particular a mains supply line filter for radio interference suppression in electrical devices and machines connected in single-phase and multiphase, with interference suppression chokes and interference suppression capacitors, in particular HF-earth-contacted Y-capacitors inserted in a metal container (1) closed by a metal cover (3) connected to the container walls by ultrasonic spot welding and which contains openings (7, 21) for electrical cables and cable plugs, where at least one of the cables is equipped with a protective conductor (5) electrically contacting the metal container (1) via an earth conductor (10) or the plug housing has a protective conductor terminal, characterised in that end (13) of the earth conductor (10) which is in electrical contact with the metal container (1) is of flat formation, is clamped between the inner wall of the metal container and the metal cover (3), and is connected by ultrasonic spot-welding to the metal container and the metal cover.

2. An interference suppression filter as claimed in Claim 1, characterised in that the earth conductor (10) additionally leads from the protective conductor (5) to the cold device plug (20) and is electrically contacted to the housing thereof.

3. An interference suppression filter as claimed in Claim 1 or Claim 2, characterised in that the earth conductor (10) leads through two ferrite tubular cores (11, 12).

4. An interference suppression filter as claimed in Claim 1, characterised in that at their ends which are electrically contacted to the metal container (1), the earth connection wires of the Y-capacitors are additionally of flat formation, are clamped between the inner wall of the metal container and the metal cover (3), and are connected by ultrasonic spot-welding to the metal container and the metal cover.

5. An interference suppression filter as claimed in Claim 1 or one of the preceding Claims, characterised in that an electrical circuit board (8) is provided as carrier and/or contact board for the components of the interference suppression filter and for the terminal ends of the electrical conductors (4, 5, 6 and 22, 23), that the earth conductor (10) which leads from the protective conductor (5) to the metal container (1) and possibly to the cold device plug (20), contacts the protective conductor via the circuit board (8), and that all the circuit board contacts are wave-soldered.

6. An interference suppression filter as claimed in Claim 1 or Claim 5, characterised in that at least one Y-capacitor (24) is arranged on the circuit board (8), and that the earth point of the circuit board which is contacted with the earth terminal of the Y-capacitor (24) is electrically connected to a copper strip (25) whose free end is clamped between the inner wall of the metal container and the metal cover (3) and is connected by ultrasonic spot-welding to the metal container (1) and the metal cover.

7. An interference suppression filter as claimed in Claim 6, characterised in that one end of the copper strip (25) is wavesoldered to the earth point of the circuit board (8).

## Revendications

1. Filtre d'antiparasitage, notamment filtre de ligne du réseau, servant à réaliser l'antiparasitage d'appareils et de machines électriques branchés selon un mode monophasé et polyphasé, et comportant des bobines d'antiparasitage et des condensateurs d'antiparasitage, notamment des condensateurs en Y comportant un contact de masse HF, qui sont installés dans un pot métallique (1) qui est fermé par un capot métallique (3) relié par soudage ultrasonique par points à la paroi du pot et comporte des traversées (7, 21) pour des câbles électriques ou des connecteurs pour câbles, l'un au moins de ces câbles étant équipé d'un conducteur de protection (5) qui est raccordé par un contact galvanique au moyen d'un conducteur de masse (10) au pot métallique (1), ou bien dans lequel le boîtier du connecteur comporte une borne de raccordement du conducteur de protection, caractérisé par le fait que l'extrémité (13) du conducteur de masse (10) qui est reliée par contact galvanique au pot métallique (1), est plate, est serrée entre la paroi intérieure du port métallique et le capot métallique (3) et est reliée au moyen d'un soudage ultrasonique par points au pot métallique et au capot métallique.

2. Filtre d'antiparasitage suivant la revendication 1, caractérisé par le fait qu'en plus du conducteur de protection (5), le conducteur de masse (10) est relié au connecteur (20) de l'appareil froid et est relié par contact galvanique au boîtier de ce connecteur.

3. Filtre d'antiparasitage selon la revendication 1 ou 2, caractérisé par le fait que le conducteur de masse (6) traverse deux noyaux de ferrite tubulaires (11, 12).

4. Filtre d'antiparasitage suivant la revendication 1, caractérisé par le fait qu'en outre les fils de raccordement à la masse des condensateurs en Y sont plats au niveau de leurs extrémités réunies par contact galvanique au pot métallique (1), sont serrés entre la paroi intérieure du pot métallique et le capot métallique (3) et sont reliés au moyen d'un soudage ultrasonique par points au pot métallique et au capot métallique.

5. Filtre d'antiparasitage suivant la revendication 1, ou l'une des revendications précédentes, caractérisé par le fait qu'il est prévu une plaquette électrique à circuits imprimés (8) servant de support et/ou une plaquette à contacts pour les composants du filtre d'antiparasitage et pour les extrémités de raccordement des conducteurs électriques (4, 5, 6 ou 22, 23), que le conducteur de masse (10) reliant le conducteur de protection (5) au pot métallique (1) et éventuellement au connecteur (20) de l'appareil froid, est raccordé par contact par l'intermédiaire de la plaquette à circuits imprimés au conducteur de protection, et que tous les contacts de la plaquette à circuits imprimés sont soudés au moyen d'une soudure à la vague.

6. Filtre d'antiparasitage suivant la revendication 1 ou 5, caractérisé par le fait qu'au moins un condensateur en Y (24) est disposé sur la plaquette à circuits imprimés (8) et que le point de masse de la plaquette à circuits imprimés, qui est réuni par contact à la borne de masse du condensateur en Y (24), est relié galvaniquement à une bande de cuivre (25) qui est serrée par son extrémité libre, entre la paroi intérieure du pot métallique et le capot métallique (3), et est relié au moyen d'un soudage ultrasonique par points au pot métallique (1) et au capot métallique.

7. Filtre d'antiparasitage suivant la revendication 6, caractérisé par le fait qu'une extrémité de la bande de cuivre (25) est soudée par soudage à la vague au point de masse de la plaquette à circuits imprimés (8).

FIG 1

22 23

21

1

8

20

14

12

A

10

11

7

4 6

5

III

III

FIG 2

14

12

11

10

A

13

FIG 3

23

21

1

3

8

11

13

10

7

6

FIG 4

14

12

A

11

10

13

## FIG 5

## FIG 6